Europäisches Patentamt

European Patent Office

Office européen des brevets

(11) Veröffentlichungsnummer: **0 405 010**

**A2**

(12) **EUROPÄISCHE PATENTANMELDUNG**

(21) Anmeldenummer: **89119661.0**

(22) Anmeldetag: **24.10.89**

(51) Int. Cl.5: **G01R 7/04**

(30) Priorität: **29.06.89 DE 3921330**

(43) Veröffentlichungstag der Anmeldung:
**02.01.91 Patentblatt 91/01**

(84) Benannte Vertragsstaaten:
**DE FR GB IT SE**

(71) Anmelder: **VDO Adolf Schindling AG**
**Gräfstrasse 103**
**D-6000 Frankfurt/Main 90(DE)**

(72) Erfinder: **Gutmann, Franz**
**Barbarossastrasse 29**
**D-6000 Frankfurt 6C(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Drehmagnet-Ouotientenmesswerk.**

(57) Die Zeigerwelle (1) eines Drehmagnet-Quotientenmeßwerkes ist nahe ihres Zeigers (2) und am ihrem Drehmagneten (4) gegenüberliegenden Ende jeweils mittels eines Radiallagers (15, 20) gelagert. Das untere, nahe des Drehmagneten (4) vorgesehene Radiallager (20) ist durch ein Sackloch (26) gebildet, in welches die Zeigerwelle (1) eingreift und in welchem sie auf einer Metallkugel (19) aufsteht. Diese Metallkugel (19) bildet deshalb ein Axiallager (20).

## DREHMAGNET-QUOTIENTENMESSWERK

Die Erfindung betrifft ein Drehmagnet-Quotientenmeßwerk, dessen einen Drehmagneten tragende Zeigerwelle nahe des Zeigers mit einem Radiallager, an einer anderen Stelle mit einem weiteren Radial Lager und an der dem Zeiger gegenüberliegenden Stirnseite mittels eines Axiallagers gelagert ist. Solche Drehmagnet-Quotientenmeßwerke werden für elektrische Anzeigegeräte in Verbindung mit einem elektrischen Geber, beispielsweise für Tachometer, eingesetzt und sind allgemein bekannt.

Bei Drehmagnet-Quotientenmeßwerken ist es erforderlich, daß der Drehmagnet möglichst genau zentrisch zu den Wicklungen gelagert ist, damit sich eine möglichst hohe Meßgenauigkeit ergibt. Bei einem bekannten Drehmagnet-Quotientenmeßwerk ist die Zeigerwelle zwischen Drehmagnet und Zeiger mit den beiden Radiallagern gelagert. Das hat zur Folge, daß sich Fluchtungsfehler der Radiallager relativ stark auswirken und es dadurch zu Meßungenauigkeiten kommt. Hierzu trägt auch bei, daß der Drehmagnet auf der dem Zeiger abgewandten Seite radial nicht gelagert ist, daß es sich also um eine fliegende Lagerung des Drehmagneten handelt.

Der Erfindung liegt die Aufgabe zugrunde, ein Drehmagnet-Quotientenmeßwerk der eingangs genannten Art mit möglichst einfachen Mitteln so auszubilden, daß Fluchtungsfehler der beiden erforderlichen Radiallager einen möglichst geringen Einfluß auf die Meßgenauigkeit des Drehmaonet-Quotientenmeßwerkes haben.

Diese Aufgabe wird erfindungsgemäß dadurch gelöst, daß das weitere Radiallager auf der dem Zeiger abgewandten Seite des Drehmagneten vorgesehen ist.

Durch diese Gestaltung haben die Radiallager einen wesentlich größeren axialen Abstand als bei den bekannten Meßwerken. Dadurch führen Fluchtungsfehler zu einer geringeren Schrägstellung der Zeigerwelle und damit des Drehmagneten, wodurch sich die Meßgenauigkeit des Drehmagnet-Quotientenmeßwerkes erhöht. Gleichzeitig ist der Drehmagnet fester gelagert, da er auf beiden Stirnseiten durch Radiallager fixiert ist.

Konstruktiv besonders einfach ist eine Ausführungsform der Erfindung, gemäß der das weitere Radiallager und das Axiallager durch ein Sackloch in einem gehäusefesten Bauteil gebildet ist, in welchen das untere Ende der Zeigerwelle eingreift und bei der in dem Sackloch eine Metallkugel eingesetzt ist, auf der die untere Stirnfläche der Zeigerwelle aufsteht. Die Kombination eines Radiallagers mit einem Axiallager führt desweiteren dazu, daß das Radiallager einen maximal großen Abstand vom Zeiger hat. Durch die Metallkugel ergibt sich eine punktförmige Abstützung der Zeigerwelle, so daß die auftretenden Reibkräfte besonders gering sind.

Fertigungstechnisch besonders günstig ist es, wenn die Metallkugel in das Sackloch eingepreßt ist.

Das zeigerseitige Radiallager läßt sich sehr genau ausrichten, wenn es an einem Lagerbock vorgesehen ist, welcher lösbar mit einem oberen Wicklungsträgerteil des Meßwerkes verbunden ist und wenn das obere Wicklungsträgerteil zwei Zentrierzapfen hat, welche jeweils in eine Zentrierbohrung des Lagerbockes greifen.

Der Werkstoff für das zeigerseitige Radiallager kann unabhängig vom Werkstoff für den Lagerbock optimal nach den Erfordernissen eines Lagers ausgewählt werden, wenn gemäß einer anderen Ausgestaltung der Erfindung das zeigerseitige Radiallager in einer von oben her in ein zur Zeigerwelle koaxiales Gewindeloch eingeschraubten Lagerschraube vorgesehen ist.

Die axiale Fixierung der Zeigerwelle kann auf einfache Weise einstellbar dadurch erfolgen, daß die Zeigerwelle im Bereich der Lagerschraube eine zum Zeiger weisende Schulter hat, der gegenüber die Lagerschraube einen Bund aufweist. Durch diese Lagerschraube kann man Fertigungsungenauigkeiten ausgleichen, indem man die Lagerschraube stets so weit in den Lagerbock schraubt, bis daß das axiale Spiel aufgehoben oder ausreichend gering ist.

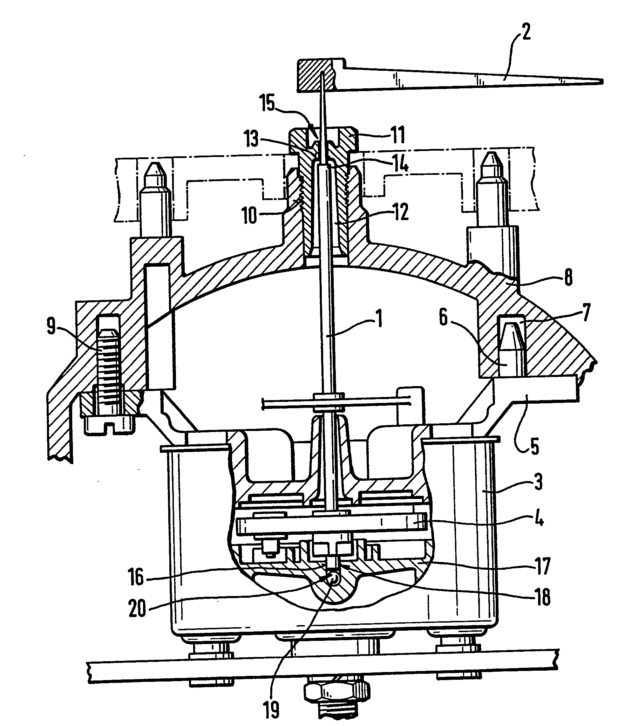

Die Erfindung läßt zahlreiche Ausführungsformen zu. Zur weiteren Verdeutlichung ihres Grundprinzips ist eine davon in der Zeichnung dargestellt und wird nachfolgend beschrieben. Die Zeichnung zeigt einen teilweisen Schnitt durch ein Drehmagnet-Quotientenmeßwerk nach der Erfindung.

In der Zeichnung ist eine Zeigerwelle 1 dargestellt, auf der ein Zeiger 2 befestigt ist. Die Zeigerwelle 1 führt in ein Gehäuse 3, wo auf ihr ein Drehmaget 4 vorgesehen ist, welcher sich innerhalb nicht gezeigter Spulen zu drehen vermag. An der Oberseite des Gehäuses 3 ist ein oberes Wicklungsträgerteil 5 zu erkennen, welches zwei nach oben gerichtete Zentrierzapfen hat, von denen ein Zentrierzapfen 6 zu sehen ist. Die Zentrierzapfen 6 greifen jeweils in eine Zentrierbohrung 7 eines Lagerbockes 8, der auf dem Wicklungsträger 5 mittels Schrauben 9 befestigt ist.

Der Lagerbock 8 hat ein mittiges Gewindeloch 10, in welches von oben her eine Lagerschraube 11 geschraubt ist. Diese Lagerschraube 11 hat einen koaxialen Durchlaß 12, durch den hindurch die Zeigerwelle geführt ist. Der Durchlaß 12 weist einen nach innen gerichteten Bund 13 auf, welcher sich oberhalb einer Schulter 14 der Zeigerwelle 1 befindet. Dadurch kann sich die Zeigerwelle 1 nicht axial aus dem Meßwerk heraus bewegen. Oberhalb des Bundes 13 ist der Durchmesser des Durchlasses 12 so stark verringert, daß ein Radiallager 15 für die Zeigerwelle 1 entsteht.

Mit ihrem unteren Ende greift die Zeigerwelle in ein Sackloch 16 eines unteren Wicklungsträgerteiles 17. Dieses Sackloch 16 ist so bemessen, daß es ein unteres Radiallager 18 für die Zeigerwelle 1 bildet. In das Sackloch 16 ist eine Metallkugel 19 eingepreßt, auf der die Zeigerwelle mit ihrer unteren Stirnfläche aufsitzt. Auf diese Weise ist dort ein Axiallager 20 gebildet.

## Ansprüche

1. Drehmagnet-Quotientenmeßwerk, dessen einen Drehmagneten tragende Zeigerwelle nahe des Zeigers mit einem Radiallager, an einer anderen Stelle mit einem weiteren Radiallager und an der dem Zeiger gegenüberliegenden Stirnseite mittels eines Axiallagers gelagert ist, dadurch gekennzeichnet, daß das weitere Radiallager (18) auf der dem Zeiger (2) abgewandten Seite des Drehmagneten (4) vorgesehen ist.

2. Drehmagnet-Quotientenmeßwerk nach Anspruch 1, dadurch gekennzeichnet, daß das weitere Radiallager (18) und das Axiallager (20) durch ein Sackloch (16) in einem gehäusefesten Bauteil gebildet ist, in welchen das untere Ende der Zeigerwelle (1) eingreift und daß in dem Sackloch (16) eine Metallkugel (19) eingesetzt ist, auf der die untere Stirnfläche der Zeigerwelle (1) aufsteht.

3. Drehmagnet-Quotientenmeßwerk nach Anspruch 2, dadurch gekennzeichnet, daß die Metallkugel (19) in das Sackloch (16) eingepreßt ist.

4. Drehmagnet-Quotientenmeßwerk nach zumindest einem der vorangehenden Ansprüche, dadurch gekennzeichnet, daß das zeigerseitige Radiallager (15) an einem Lagerbock (8) vorgesehen ist, welcher lösbar mit einem oberen Wicklungsträgerteil (5) des Meßwerkes verbunden ist und daß das obere Wicklungsträgerteil (5) zwei Zentrierzapfen (6) hat, welche jeweils in eine Zentrierbohrung (7) des Lagerbockes (8) greifen.

5. Drehmagnet-Quotientenmeßwerk nach zumindest einem der vorangehenden Ansprüche, dadurch gekennzeichnet, daß das zeigerseitige Radiallager (15) in einer von oben her in ein zur Zeigerwelle (1) koaxiales Gewindeloch (10) eingeschraubten Lagerschraube (11) vorgesehen ist.

6. Drehmagnet-Quotientenmeßwerk nach zumindest einem der vorangehenden Ansprüche, dadurch gekennzeichnet, daß die Zeigerwelle (1) im Bereich der Lagerschraube (11) eine zum Zeiger (2) weisende Schulter (14) hat, der gegenüber die Lagerschraube (11) einen Bund (13) aufweist.